# EUROPEAN PATENT APPLICATION

(11) **EP 4 826 758 A1**
(43) Date of publication of application: **21.10.2026**
(21) Application number: 24904069.2
(22) Date of filing: 26.11.2024
(51) Int. Cl.: H01J 37/05, H01J 37/22, H01J 37/28

(54) **ATMOSPHERIC PRESSURE ELECTRON MICROSCOPE USING MULTI-WINDOW THIN FILM**

(30) Priority: 15.12.2023 KR 20230182924
(71) Applicant: Coxem Co., Ltd., Daejeon 34025 (KR)
(72) Inventor: HONG, Jae Wan, Seoul 08520 (KR); KIM, Deuk Hyeon, Daejeon 34201 (KR); HA, Min Su, Daejeon 34307 (KR); LEE, Jun Hee, Daejeon 34090 (KR)
(74) Representative: Habermann, Hruschka & Schnabel
(86) International application number: PCT/KR2024/018839
(87) International publication number: WO 2025/127504

(57) **Abstract**

The present invention relates to an atmospheric pressure electron microscope comprising a multi-window thin film unit formed by covering a support part (window frame) having a plurality of windows with an ultra-thin film, and an image is obtained by irradiating electrons onto a sample through the multi-window thin film unit, and multiple images taken while moving the sample at a predetermined interval are synthesized by image stitching to obtain an image of the sample.

## Description

### TECHNICAL FIELD

The present invention relates to an atmospheric pressure electron microscope, and more specifically, to an atmospheric pressure electron microscope having a multi-window thin film unit which comprises a support part having a plurality of windows and an ultra-thin film covering the windows, and an image is obtained by irradiating electrons onto a sample through the multi-window thin film unit, and a plurality of images taken while moving the sample at a predetermined distance are synthesized by image stitching to obtain a completed image of the sample.

This application claims priority based on Korean Patent Application No. 10-2023-0182924 (Title: Atmospheric pressure electron microscope using a multi-window thin film, Filing Date: December 15, 2023), and all contents of the specification and drawings of the Korean Patent Application are incorporated herein by reference.

### BACKGROUND ART

An atmospheric pressure electron microscope (Air-SEM) is an electron microscope that observes samples located in atmospheric or low vacuum conditions, rather than in high vacuum. The atmospheric pressure electron microscope offers higher resolution and a deeper depth of focus than optical microscopes, allowing for clearer observation of living biological samples.

The atmospheric pressure electron microscope comprises a column having a high-vacuum interior space, a thin film installed at a bottom of the column to separate the interior space from an exterior, and a sample stage installed under the thin film.

A distance (mean-free path: MFP) that electrons freely travel in the atmosphere without colliding with molecules is tens to hundreds of µm or less. A longer MFP reduces electron scattering, resulting in a stronger signal and lower noise, and causes a higher signal-to-noise ratio and higher image quality. Since the MFP is significantly affected by a number of molecules along the electron path, a higher vacuum level leads to a longer MFP. Therefore, the interior space of the column, which occupies most of the electron path, must be maintained at a high vacuum, while a low vacuum or atmospheric pressure must be created only near the sample to minimize the electron scattering. The high vacuum space and the low vacuum space are isolated by a thin film near the sample. This thin film allows electrons having small size to pass through, while blocks atoms having much larger size than the electrons. Electrons generated from an electron gun pass through the interior space without scattering, and irradiates the sample after scattered by the thin film (film transmittance: a) and the air surrounding the sample. The electrons irradiating the sample generate backscattered electrons (BSE), which then pass through the thin film (transmittance: b. a≈b) and are detected by a backscattered electron detector.

The rate (electron transmittance) at which the electrons pass through the thin film increases with thinner films, resulting in better image quality. Furthermore, larger film area increases a field of view (FOV) of the electron microscope. However, the thin film must be manufactured to withstand deformation and damage caused by the pressure difference between the two spaces, and must guarantee a certain service life (durability). Therefore, the feasibility of manufacturing and applying a single window having a thin, wide film is very low.

### DISCLOSURE

### Technical Goal

1) Conventional atmospheric pressure electron microscopes either use thick Si₃N₄ films (typically 20 nm thick) or, when using thin films (1 nm or less than 1 nm), must reduce the film area to prevent damage due to the pressure difference at the interface between atmospheric pressure and high vacuum. The thick films lead to significant losses in resolution and contrast and the thin films limit the FOV, which cause a critical weakness for the commercialization of the atmospheric pressure electron microscopes. To solve the problems, multiple small windows are created in the thick, durable thin film (the small windows are arranged in one or two dimensions), and an ultra-thin film (e.g., an ultra-thin film made of graphene or other 2D materials) that allows electrons to pass through covers the multiple small windows entirely (i.e., two-layer structure having multi window-ultra thin film).
   Since the force exerted on the ultra-thin film due to the pressure difference (F=PA, where P is the pressure difference and A is the area) is proportional to the area, dividing the window size into multiple sections reduces the force exerted on a single ultra-thin film, thereby preventing deformation or damage of the individual ultra-thin film window. The window frame serves as a mechanical support for the ultra-thin film and is an area where the electrons cannot path through. Only electrons that pass through the ultra-thin film which is applied to the windows are used for image acquisition.
2) A problem with 1) above is a generation of blind areas in the image caused by the thin film window frame where the electrons cannot pass through. Therefore, the purpose of the present invention is to eliminate the blind areas in the image by a stitching algorithm for the multiple images acquired by multiple scans by linking the movement of the sample (specimen) according to a structure of the multiple-window.

Therefore, applying the above-described method is expected to not only improve the resolution and clarity of atmospheric pressure electron microscopy, but also serve as a useful means for realizing atmospheric pressure electron microscopy technology having a wide FOV.

### Technical solution

A quality of a sample's image is directly proportional to a number of electrons detected by the BSD (Backscattered Electron Detector).

The probability (Pₜₒₜₐₗ) that the electron reaches the BSD can be calculated by Equation 1 below. [Equation 1] ${P}_{total} = a \times b \times {P}_{S}$

And since a≈b (in case that energies of the BSE electrons and incident electrons are nearly equal), ${P}_{total} = {a}^{2} \times {P}_{S}$

In the above equation,
Pₜₒₜₐₗ : probability that the BSE reaches the BSD
a : probability that the incident electrons pass through the thin film (The 'a' depends on a thickness of the thin film)
Ps : probability that the electrons incident on the sample through the atmosphere generate the BSE and then pass through the atmosphere again to reach the thin film (dependent on atmospheric effects, i.e., pressure and atmospheric thickness (WD))
b: probability that the BSE passes backward through the thin film (The 'b' depends on the thickness of the thin film)

The number of electrons detected in the BSD can be calculated using Equation 2 below. [Equation 2] ${N}_{o} = {P}_{total} \times {N}_{i} = {a}^{2} \times {P}_{S} \times Ni$

In the equation above,
Nᵢ : total number of electrons irradiated to the thin film in the electron-optical system
Nₒ : total number of electrons detected by the BSD

To increase the a, it is advantageous to thin a thickness of the thin film, and to increase Ps, it is advantageous to reduce the WD (working distance, the distance between the thin film and the atmosphere).

Problem 1: As the thickness of the thin film is reduced, the area of the thin film must be reduced to prevent damage. However, this reduction in area reduces the FOV.

Problem 2: To increase Ps, the WD must be reduced. However, when the WD is very small, the window size (the area of the thin film) ≈ FOV. Therefore, to increase the FOV, the area of the thin film must be increased.

Therefore, to resolve the conflicting problem 1 and 2, a two-layer structure consisting of an ultra-thin film and a thick thin film with a large multi-window area is a solution.

The present invention relates to an atmospheric pressure electron microscope that utilizes a wide-area ultra-thin film (solving the problem 1) and provides a wide field of view (solving the problem 2) even with a small WD.

Specifically, an atmospheric pressure electron microscope 100 according to a preferred embodiment of the present invention is designed to observe a sample S placed in a space 1 that is a lower vacuum or atmospheric pressure than an interior space of a column 10. The electron microscope 100 may include a multi-window thin film unit 50 that separates the interior space from the space 1; a sample stage 60 on which the sample S is placed and which is movable on a plane; a control unit that controls the movement of the sample stage 60; and a computation unit that performs image stitching for at least two photographed images.

The multi-window thin film unit 50 is a through-type window with multiple windows 53 formed in a thick thin film that impedes a pass-through of the electrons. A support part 52 serves as a window frame, acts as an adhesive surface for an ultra-thin film 54, and supports the ultra-thin film 54. The ultra-thin film 54 is applied to cover the windows 53 and the support part 52 (window frame) entirely. Electrons pass through the ultra-thin film 54 well, but air cannot pass through the ultra-thin film 54. Therefore, the ultra-thin film 54 separates the space 1 of the atmospheric pressure or low-vacuum from the high-vacuum space 11.

The control unit photographs the sample S and then moves the sample stage 60 to photograph an image of the sample, ensuring that the images photographed before and after the movement overlap at least partially. The computation unit stitches to synthesize the overlapping images to create an entire image.
1) When the windows 53 are arranged one-dimensionally, the windows 53 have a predetermined width xₒ and a predetermined length yₒ, and are repeatedly formed at a first interval x₁ along a first direction (e.g., the x-direction). The width xₒ may be longer than the first interval xi, and the length yₒ may be equal or longer than a length of a portion to be photographed.

The control unit, after photographing the sample S for the first time, moves the sample stage 60 along the first direction to take a second image, such that the images photographed before and after the movement overlap at least partially. The computation unit can then stitch the images photographed at least the first and second images to create an image of the sample. Depending on the situation, the sample movement distance and number of movements may be varied, and in this case, three or more images may be acquired and utilized for the image stitching, thereby improving an accuracy of the image stitching.

2) As an alternative to the one-dimensional arrangement, when the windows 53 are arranged two-dimensionally, the windows 53 may have a predetermined width xₒ and a predetermined length yₒ, and may be repeatedly formed at a first interval x₁ along a first direction (e.g., the x-direction) and at a second interval y₁ along a second direction (e.g., the y-direction).

It is preferable that the width xₒ is longer than the first interval xi, and the length yₒ is longer than the second interval y₁.

The control unit may, after first photographing the sample S, move the sample stage 60 along the first and the second directions, respectively, to photograph second and third images, such that the images photographed before and after the movement overlap at least partially. The computation unit may image stitch at least the first, the second, and the third photographed images to create an image of the sample. Depending on the situation, the sample movement distance and number of movements can be varied, in which case three or more images can be acquired and used for the image stitching to improve an accuracy of image stitching.

A multi-window thin film unit 50 includes a frame 51, and a penetration portion 51a may be formed in the frame 51. The frame 51 may be made of silicon (Si). A support part 52 (window frame) is installed and attached on a lower surface of the frame 51 so that the multiple windows 53 are correspond to the penetration portion 51a. And, an ultra-thin film 54 is installed on a lower surface of the support part 52 so as to cover the entire multiple windows 53. An outermost side surface of the penetration portion 51a is formed as an inclined surface, and thus, an upper portion of the penetration portion 51a has a larger diameter than a lower portion.

The support part 52 is a thick thin film having a thickness of approximately 20 nm to 1 µm, and may be made of Si₃N₄. Since the support part 52 is intended to support the ultra-thin film 54, it is preferable that the support part 52 is a film thicker than the ultra-thin film 54. The ultra-thin film 54 can be made of graphene or other 2D materials with high electron transmittance.

The atmospheric pressure electron microscope may include a lower chamber 80 installed below the column 10 and having a low-vacuum space 81 formed inside. A multi-window thin film unit 50 may be installed at a bottom of the lower chamber 80. The electrons generated from an electron gun sequentially pass through the interior space 11, the low-vacuum space 81, and the multi-window thin film unit 50 to irradiate the sample S. The low-vacuum space 81 serves as an intermediate vacuum region to minimize the pressure difference applied to the ultra-thin film 54, thereby mitigating damage to the ultra-thin film 54.

### Advantageous Effects

The atmospheric pressure electron microscope according to the present invention has the following effects.

First, the resolution and clarity of the image are improved by utilizing the multi-window thin film unit having a thin thickness and a large-area.

Second, a wide field of view can be provided even using an ultra-thin film.

Third, due to an improved signal-to-noise ratio (SNR) and increased FOV, high FPS (Frames Per Second) images can be acquired for a large area compared to the conventional single-window thin film.

### DESCRIPTION OF DRAWINGS

FIG. 1 is a diagram showing main configurations of an atmospheric pressure electron microscope according to a preferred embodiment of the present invention.
FIG. 2 is a cross-sectional view showing a multi-window thin film unit of FIG. 1.
FIG. 3 is a plan view showing windows repeatedly formed at a first interval in a first direction (x-axis direction) in a support part (thick thin film) of the multi-window thin film unit, and an ultra-thin film installed on the windows.
FIG. 4 is a plan view showing windows repeatedly formed at a first interval in a first direction (x-axis direction) and at a second interval in a second direction (y-axis direction), and an ultra-thin film is installed on the windows.
FIG. 5 shows an image (left) photographed using the multi-window thin film unit having a two-dimensional 3x3 array of graphene windows, and a graph (right) showing a signal intensity of points connecting points A and B in the left image.
FIG. 6 is a cross-sectional view showing a modified example of an atmospheric pressure electron microscope, in which a lower chamber is installed at a bottom of a column and a BSD is installed at a bottom of the lower chamber.
FIG. 7 is a cross-sectional view showing another modified example of an atmospheric pressure electron microscope, in which a lower chamber is installed at a bottom of a column and a BSD is installed at a bottom of the column.

### BEST MODE

Hereinafter, the present invention will be described in detail with reference to the attached drawings. Prior to this, the terms and words used in this specification and claims should not be interpreted solely based on their conventional or dictionary meanings. Based on the principle that inventors can appropriately define the concepts of terms to best explain their inventions, they should be interpreted with meanings and concepts consistent with the technical concept of the present invention. Therefore, the embodiments described in this specification and the configurations depicted in the drawings are merely exemplary embodiments of the present invention and do not fully represent the technical concept of the present invention. Therefore, it should be understood that various equivalents and modifications may be substituted for them at the time of filing.

In the drawings below, identical reference numerals denote identical or substantially identical components. In addition, the x, y, and z axes in the drawings represent the three axes of a Cartesian coordinate system, which are depicted for ease of understanding and explanation, and the x, y, and z axes are perpendicular to each other.

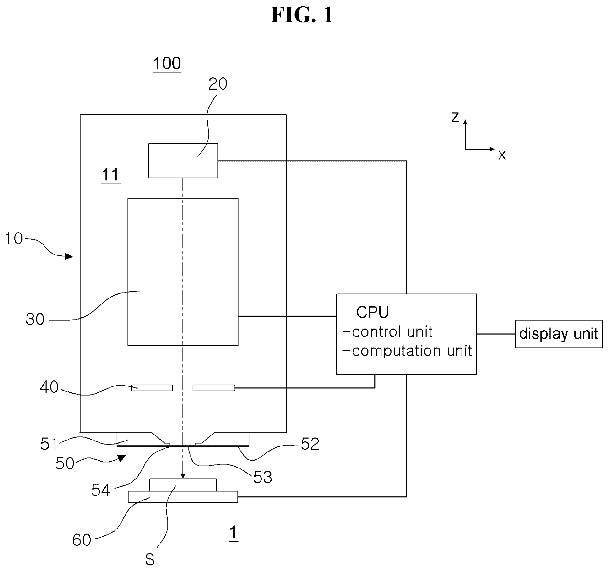

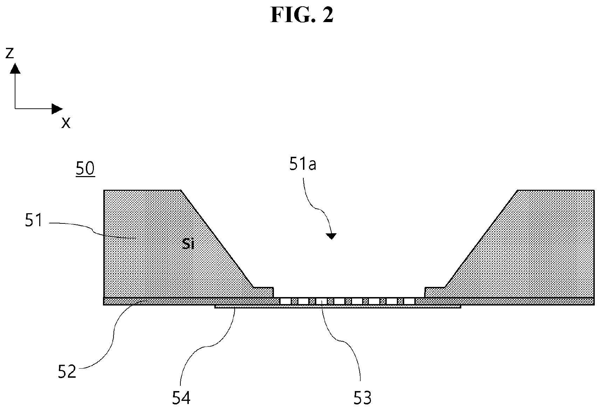

FIG. 1 is a diagram illustrating main configurations of an atmospheric pressure electron microscope according to a preferred embodiment of the present invention, and FIG. 2 is a cross-sectional view showing a multi-window thin film unit of FIG. 1. In FIG. 1, the blue lines represent paths along which various electrical control signals, data, and images etc. are transmitted, while the red lines represent paths along which electrons generated from an electron gun travel to a sample.

As shown in the drawings, the atmospheric pressure electron microscope 100 may include a column 10, a multi-window thin film unit 50, a sample stage 60, and a central processing unit.

The column 10 has a high-vacuum space 11 within it. The column 10 may house an electron gun 20 that generates electrons, an electron optical system 30 including focusing lenses, objective lenses, a deflector, and the like, and a backscattered electron detector (BSD) 40 etc.. Since a configuration of the electron gun 20 is well known, its description will be omitted here.

The electron optical system 30 can change an electron movement path according to a control signal transmitted from a control unit of the central processing unit (CPU). Preferably, this control signal can be linked to a movement of the sample stage 60. For example, a deflector (or scanner) in the electron optical system 30 can adjust the electron beam movement path to allow electrons to pass through a specific window 53 among multiple windows 53 or all windows 53.

The BSD 40 may be installed under the electron optical system (30). Alternatively, the BSD 40 may be installed on a lower surface of a frame (51) of the multi-window thin film unit 50.

The BSD (40) detects backscattered electrons and transmits the signal to the central processing unit, and the computation unit of the central processing unit processes, for example, image stitches the transmitted signal to generate an entire image and output it to a display unit.

The multi-window thin film unit 50 may be installed at a bottom of the column 10. The multi-window thin film unit 50 may include a frame 51, a support part 52 (window frame) installed (attached) to a lower surface of the frame 51, and an ultra-thin film 54 installed to cover a lower surface of the support part 52.

The frame 51 may be installed at a lower surface of the column 10. In addition, a penetration portion 51a is formed at a center of the frame 51. The penetration portion 51a is a hole formed to vertically penetrate the frame 51, and its side surfaces are inclined, so that an upper portion of the penetration portion 51a has a larger diameter than a lower portion. The frame 51 may be made of silicon. The penetration portion 51a may be manufactured to have various shapes such as variations of a square.

The support part 52 (window frame) is a film having a predetermined thickness and is installed (or attached) to the lower surface of the frame 51 to cover the penetration portion 51a. A plurality of windows 53 are formed to penetrate the support part 52, and the support part 52 may be attached to the frame 51 so that all of the windows 53 correspond to the penetration portion 51a.

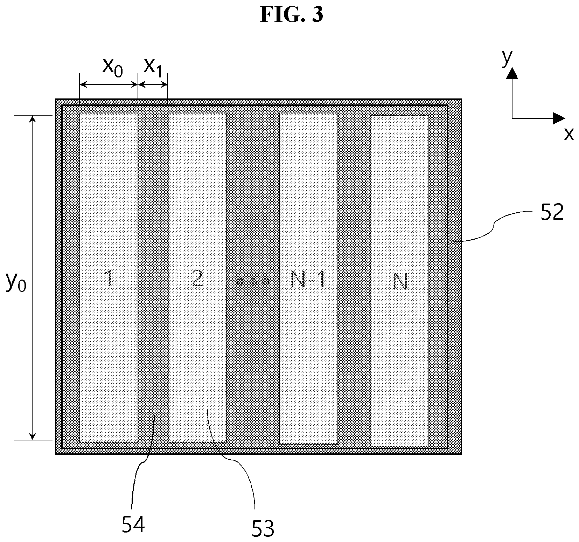

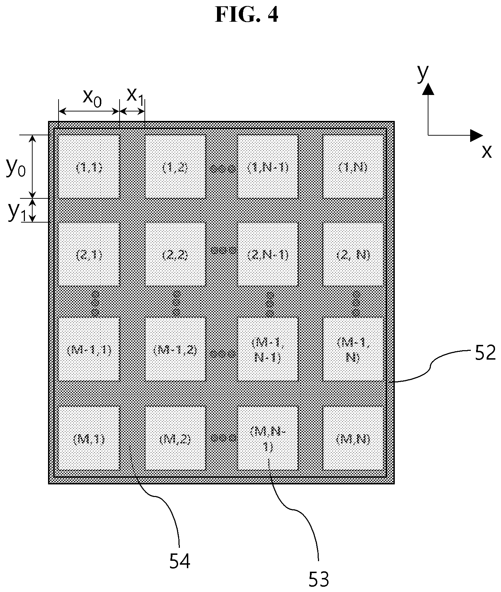

The windows 53 are holes through which electrons pass, and the support part 52 except for the windows 53 does not allow electrons to pass. Windows 53 of the same shape can be repeatedly formed to form a pattern. For example, as shown in FIG. 3, rectangular windows 53 having a long length can be repeatedly formed along the x-direction (first direction), or as shown in FIG. 4, square windows 53 can be repeatedly formed along the x-direction (first direction) and the y-direction (second direction). Preferably, the support part 52 is a thick thin film made of SiNₓ (e.g., Si₃N₄) with a thickness of 20 nm or more, thicker than the ultra-thin film 54.

The thick thin film 52 may have an area of 3 mm × 3 mm and may be attached to a predetermined frame (a wafer piece on which a BSD is manufactured, for attaching the BSD in the air) using wax or epoxy. The windows 53 may be patterned using photolithography and reactive ion etching.

The ultra-thin film 54 is attached to the lower surface of the support part 52(window frame) so as to cover the entire multiple windows 53. The ultra-thin film 54 allows electrons to pass through, but doesn't allow air to pass through. The ultra-thin film 54 can be made of graphene or a two-dimensional material (2D material) with high electron transmittance. Typically, the ultra-thin film 54 may have a thickness of integer multiple of a single layer of graphene or other 2D material, preferably a thickness of 1 to 10 nm is desirable taking into account resolution and strength.

If the Si₃N₄ thin film of the support part 52 (window frame) is less than 20 nm thick and has a side width of more than or equal to 200µm, it will be difficult to withstand a pressure difference between the two spaces and will have a shortened service life. Furthermore, if the thickness exceeds 1µm, electrons may be scattered from sides of the window formed in the thick thin film, resulting in poor image clarity.

In the conventional atmospheric pressure electron microscope technology, the thick thin film 52 without a window was used, and it was difficult to make the Si₃N₄ thin and uniform at a level of several nm in thickness. Because of this, the conventional atmospheric pressure electron microscope technology had to use the thick thin film of 20nm or more for strength, which limited a resolution and clarity of the image. Graphene having a single layer of 0.2 nm thickness can be made to have a uniform thickness of several nm by stacking multiple layers. Graphene has been used to wrap samples for observing them in a vacuum, and recent studies have shown that the thin film made of graphene provides an electron transparent window with a contrast reduction of only 2%. Therefore, when a graphene thin film 54 (ultra-thin film) is applied to the support part 52 with windows 53 and used as an electron transmission window of the atmospheric pressure electron microscope, a signal/noise ratio is improved by five times compared to the Si₃N₄ thin film, thereby enabling high contrast in backscattering, transmission and surface imaging modes. In addition, since the graphene thin film (ultra-thin film, 54) exhibits excellent electron transmittance, it has significantly reduced electron beam degradation and contamination compared to the Si₃N₄, and exhibiting superior mechanical durability.

FIG. 3 shows a window 53 repeatedly formed one-dimensionally in the support part 52 (thick thin film). Specifically, the window 53 is a rectangular hole with a very long length yₒ compared to its width xₒ, and is repeatedly formed at a first interval x₁ along a first direction (x-axis direction). It is preferable that the width xₒ be longer than the first interval xi, and the length yₒ be longer than or equal to a length of the area to be photographed. If the length yₒ is longer than or equal to the length of the area to be photographed, an entire image can be acquired with just one offset of the sample stage 60 in x-axis direction, thus reducing an image capture time.

Approximately, the width xₒ is preferably at least 1µm and at most 10µm, but can be adjusted depending on the thickness of the ultra-thin film 54. The length yₒ may vary depending on the width xₒ but can be determined based on the maximum field of view. The length yₒ is preferably at least 100µm and at most 1mm.

The offset distance can be expressed by the following equation. $Offset in the x - axis direction = {x}_{o} - Δx$

In the equation above,
Δx : a length of the overlapping portion photographed in the x-axis direction before and after the x-axis offset.

It is desirable to ensure that 'the width xₒ > the first interval x₁'. And to acquire an image of the rectangle part of x₁, it is desirable to adjust 'the offset in the x-axis direction = xₒ - Δx ≤ 0.9xₒ' to have the overlapped part Δx to be at least 10% of the width xₒ to facilitate the image stitching.

The control unit takes the first image without moving the sample S, then moves the sample stage 60 along the first direction (x-axis direction) to take the second image, ensuring that the images taken before and after the movement overlap at least partially. The control unit then transmits signals of the photographed images to the computation unit, which then stitches the first and second images to create an entire image.

A maximum scan area of the entire image can be calculated using the following equation: [Equation 4] $\begin{matrix}{L}_{x} = {P}_{x} \times N \\ {P}_{x} = {x}_{0} + {x}_{1}\end{matrix}$

In the equation above,
Lₓ : maximum scan area (or area of the maximum scan area)
N : number of windows 53
Pₓ : interval at which windows 53 are repeated

In the above, the rectangular window 53 is described as an example, but various shapes of windows are possible. For example, the above explanation can also be applied to a one-dimensional arrangement of peanut-shaped windows (not shown). In the case where rectangular windows 53 or peanut-shaped windows are repeatedly formed in one dimension (1D array scanning), only two shots are required to obtain one image, which is advantageous over a two-dimensional array (2D array scanning). Of course, the scope of the present invention does not exclude shooting three or more times (i.e., additional offset and shooting in the x-axis direction after the second shooting) to increase the accuracy of the image stitching when windows 53 are repeatedly arranged in one dimension.

FIG. 4 is a plan view showing windows 53 repeatedly formed in a support part 52 (thick thin film) at a first interval in the x-axis direction and a second interval in the y-axis direction, and an ultra-thin film 54 installed on the windows 53.

That is, approximately square window 53 having a predetermined width xₒ and a predetermined length yₒ is repeatedly formed at a first interval x₁ along a first direction (x-axis direction) and at a second interval y₁ along a second direction (y-axis direction). Furthermore, the width xₒ is longer than the first interval xi, and the length yₒ is longer than the second interval y₁.

The control unit performs a first photographing without moving the sample S, and then moves (offsets) the sample stage 60 along the first direction and the second direction respectively to perform a second and third photographs, which are described in detail below.
(i) First photographing
   Photographing is performed without moving the sample stage 60. That is, the x-axis offset = 0, the y-axis offset = 0.
(ii) Second photographing
   Photographing an image by moving the sample stage 60 by 'Δx' in the x-axis direction and not moving (offsetting) it in the y-axis direction.
(iii) photographing an image by moving the sample stage 60 by 'Δy' in the y-axis direction and not offsetting it in the x-axis direction.
(iv) Image Stitching

The three images photographed in steps (i) to (iii) above are stitched and synthesized in two dimensions by the computation unit.

In the above, xₒ > x₁ and yₒ > y₁. And, a size of the rectangular region is proportional to the lengths of x₁ and y₁.

To optimize the image acquisition of the rectangular region, it is desirable to adjust the offsets as follows.
Offset in the x-axis direction ≤ 0.9×xₒ
Offset in the y-axis direction ≤ 0.9×yₒ

In the case like this where a window 53 is formed in two dimensions repeatedly (2D array), photographing must be performed three or more times to obtain one image. However, compared to a conventional single window (single hole), the ultra-thin film 54 can be made thinner, resulting in a higher SNR than the conventional thick thin films. This allows for increased scanning speeds, allowing for images to be photographed at sufficient FPS even with multiple scans.

Meanwhile, the sample stage 60 can be moved on a plane (along the x-axis and y- axis) while the sample S is loaded onto its upper surface. In an atmospheric pressure electron microscope, the sample stage 60 is placed in an atmospheric pressure space or a low-vacuum space.

The offset movement of the sample stage 60 is intended to photograph images of areas (rectangle areas) obscured by the support part 52 (window frame). To ensure precise movement and high scanning speed, a piezo stage is preferably used, but is not necessarily limited to this. The piezo stage is a stage designed to achieve 1nm precision positioning by combining a piezoelectric element and a displacement measurement sensor. Since its configuration is well known, its description will be omitted here.

The applicant achieved 6 FPS (TV mode) using the above-described method, confirming that the frame rate is similar level with the typical image acquisition speed.

The central processing unit (CPU) includes a control unit and a computation unit. As described above, the control unit controls an operation of the electron gun 20, the electro-optical system 30, the BSD 40, and the sample stage 60. When an user inputs the offsets in the x-axis and y-axis directions, the control unit transmits corresponding inputs to the sample stage 60, and the sample stage 60 moves in accordance with the inputs.

And, the control unit controls a scanner of the electro-optical system 30 to control a position and deflection of an electron beam. This control can be linked to the offsets of the sample stage 60.

Additionally, multiple image signals transmitted from the BSD 40 are image stitched to be synthesized by the computation unit, and this synthesized image is finally displayed on a display unit.

The scanner of the electro-optical system 30 can change an electron path according to a control signal transmitted from the control unit. Preferably, this control signal can be linked to the movement of the sample stage 60. For example, the electro-optical system 30 can adjust the electron path to allow electrons to pass through the entire windows or some selected windows 53 or a specific single window 53 to acquire an image. When the electrons for the scanning pass through the specific single window 53, a high-magnification image can be acquired without image stitching, thereby speeding up an image update speed compared to using multi windows.

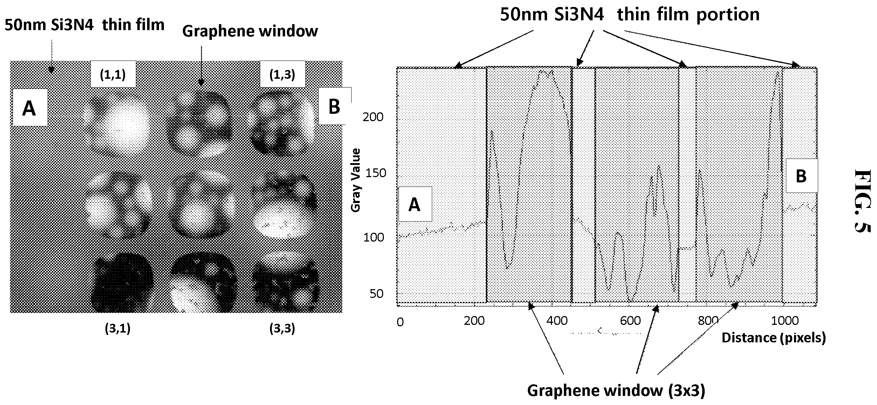

Meanwhile, FIG. 5 shows an image (left) photographed using a multi-window thin film unit 50 with a two-dimensional 3x3 array of graphene windows 53, and a graph (right) showing a signal intensity of points connecting points A and B in the left image.

3×3 (a total of nine) square holes (windows, 53) were created in the support part 52 (a thick thin film made of Si₃N₄) of 50nm thickness, and the support part 52 was entirely covered with four to five layers of graphene. The image on the left in Fig. 5 is an image of the atmospheric pressure electron microscope photographed using this multi-window thin film unit 50, and the graph on the right shows the signal intensity of points connecting points A and B in the left image. The light green portions in the graph represents the support part (Si₃N₄, thickness: 50 nm), and the red portions represents the area of the window 53 of graphene (less than 1nm thickness, composed of four to five stacked graphene monolayers). The signals generated by the electrons passing through the graphene windows 53 are much stronger and has less noise than the signals generated by the electrons passing through the support part 52 (Si₃N₄).

### [Modified Example of an atmospheric pressure electron microscope]

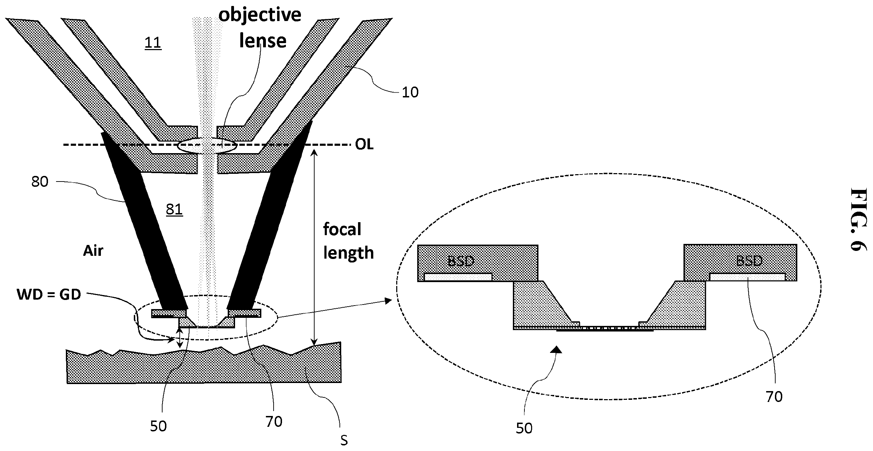

FIG. 6 is a cross-sectional view showing a modified example of an atmospheric pressure electron microscope. This atmospheric pressure electron microscope has a lower chamber 80 installed at a bottom of the column 10, and an interior of the lower chamber 80 is a low-vacuum space 81. A multi-window thin film unit 50 is installed at a bottom of the lower chamber 80. Electrons generated from the electron gun 20 sequentially pass through the interior space 11 of the column 10, the objective lens, the low-vacuum space 81, and the multi-window thin film unit 50 to irradiate the sample S. The multi-window thin film unit 50 can be bonded to a lower surface of the BSD 70 using UV epoxy.

The low vacuum space 81 reduces a stress acting on the multi-window thin film unit 50 by reducing a pressure difference between an upper part and a lower part of the multi-window thin film unit 50.

In the atmospheric pressure electron microscope 100 of FIG. 1, the BSD 40 is installed inside the column 10, so backscattered electrons must pass through the multi-window thin film unit 50. However, in this atmospheric pressure electron microscope, the BSD 70 is installed at the bottom of the lower chamber 80, so BSE can be detected without having to pass through the multi-window thin film unit 50 again. This allows for a detection of BSE scattered at a large angle, which is advantageous for side observation of samples with a large inclination.

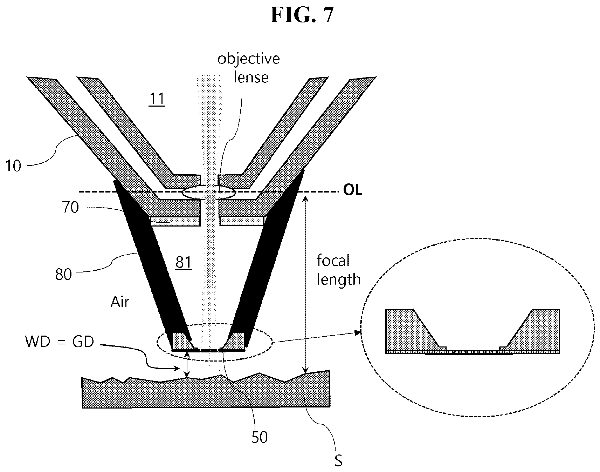

Meanwhile, FIG. 7 shows that the BSD 70 is installed inside the lower chamber 80 but is installed at the bottom of the column 10, and since a distance between the sample S and the BSD 70 is far, it mainly detects signals scattered at a low angle.

## Claims

1. An atmospheric pressure electron microscope using multi-window thin film to observe a sample S placed in a space 1 that is at a lower vacuum or atmospheric pressure than an interior space of a column 10,
the atmospheric pressure electron microscope comprising:
a multi-window thin film unit 50 separating the interior space from the space 1;
a sample stage 60 on which the sample S is placed and movable on a plane;
a control unit for controlling a movement of the sample stage 60; and
a computation unit for image stitching at least two photographed images;
wherein the multi-window thin film unit 50 comprises,
a support part 52 through which multiple windows 53 are formed in film that does not allow electrons to pass through; and
an ultra-thin film 54 installed on the support part 52 to cover the windows 53;
wherein the electrons pass through the ultra-thin film 54, but air cannot pass through the ultra-thin film 54,
wherein the control unit moves the sample stage 60 and photographs the sample S after photographing the sample S, such that images photographed before and after the movement overlap at least partially with each other;
wherein the computation unit performs an image stitching the overlapped images to synthesize an image of the sample.

2. The atmospheric pressure electron microscope according to claim 1,
wherein the window 53 has a predetermined width xₒ and a predetermined length yₒ and is repeatedly formed at a first interval x₁ along a first direction, and the width xₒ is longer than the first interval x₁ and the length yₒ is equal or longer than a length of a portion to be photographed,
wherein the control unit takes a first image of the sample S and then moves the sample stage 60 along the first direction to take a second image, such that the images taken before and after the movement overlap at least partially with each other,
wherein the computation unit stitches at least the first and the second images to create the image of the sample.

3. The atmospheric pressure electron microscope according to claim 1
wherein the window 53 has a predetermined width xₒ and a predetermined length yₒ, and is repeatedly formed at a first interval x₁ along a first direction, and is repeatedly formed at a second interval y₁ along a second direction,
wherein the width xₒ is longer than the first interval xi, and the length yₒ is longer than the second interval y₁,
wherein, after first photographing the sample S, the control unit moves the sample stage 60 along the first and second directions, respectively, to take second and third photographs, such that the images taken before and after the movement overlap at least partially with each other,
wherein the computation unit stitches at least the first, second, and third images to create the image of the sample.

4. The atmospheric pressure electron microscope according to any one of claim 1 to 3,
wherein the multi-window thin film unit 50 includes a frame 51, and a through-hole 51a is formed in the frame 51,
wherein the support part 52 is attached on a lower surface of the frame 51 so that all windows 53 corresponds to the through-hole 51a, and the ultra-thin film 54 is attached on a lower surface of the support part 52 so that the ultra-thin film 54 cover all windows 53,
wherein a side surface of the through-hole (51a) is formed as an inclined surface, and a diameter of an upper portion of the through-hole 51a is larger than a diameter of a lower portion of the through-hole 51a.

5. The atmospheric pressure electron microscope according to claim 4,
wherein the support part 52 is a thin film having a thickness of 20nm to 1µm, which is thicker than the ultra-thin film 54, and
the ultra-thin film 54 is made of graphene or a two-dimensional material (2D material) having high electron transmittance.

6. The atmospheric pressure electron microscope according to any one of claim 1 to 3,
wherein the atmospheric pressure electron microscope further includes a lower chamber 80 installed at a bottom of the column 10 and having a low vacuum space 81 therein,
wherein the multi-window thin film unit 50 is installed at a bottom of the lower chamber 80, and electrons generated from the electron gun sequentially pass through the interior space, the low vacuum space 81, and the multi-window thin film unit 50 to irradiate on the sample.

## Amended claims

### Amended claims under Art. 19.1 PCT

1. An atmospheric pressure electron microscope using multi-window thin film to observe a sample S placed in a space 1 that is at a lower vacuum or atmospheric pressure than an interior space of a column 10,
the atmospheric pressure electron microscope comprising:
a multi-window thin film unit 50 separating the interior space from the space 1;
a sample stage 60 on which the sample S is placed and movable on a plane;
a control unit for controlling a movement of the sample stage 60; and
a computation unit for image stitching at least two photographed images;
wherein the multi-window thin film unit 50 comprises,
a support part 52 through which multiple windows 53 are formed; and
an ultra-thin film 54 installed on the support part 52 to cover the windows 53;
wherein electrons pass through the ultra-thin film 54, but air cannot pass through the ultra-thin film 54,
wherein the support part 52 is thicker than the ultra-thin film 54 and supports the ultra-thin film 54,
wherein the control unit moves the sample stage 60 and photographs the sample S after photographing the sample S, such that images photographed before and after the movement overlap at least partially with each other,
wherein the computation unit performs an image stitching using the overlapped image portions to synthesize an image of the sample.

2. The atmospheric pressure electron microscope according to claim 1,
wherein the image stitching performed by the computation unit synthesizes only a portion of the image of the sample S corresponding to the windows 53 in the photographed images.

3. The atmospheric pressure electron microscope according to claim 1 or 2,
wherein the window 53 has a predetermined width xₒ and a predetermined length yₒ and is repeatedly formed at a first interval x₁ along a first direction, and the width xₒ is longer than the first interval x₁ and the length yₒ is equal or longer than a length of a portion to be photographed,
wherein the control unit takes a first image of the sample S and then moves the sample stage 60 along the first direction to take a second image, such that the images taken before and after the movement overlap at least partially with each other,
wherein the computation unit stitches at least the first and the second images to create the image of the sample.

4. The atmospheric pressure electron microscope according to any one of claim 1 or 2,
wherein the window 53 has a predetermined width xₒ and a predetermined length yₒ, and is repeatedly formed at a first interval x₁ along a first direction, and is repeatedly formed at a second interval y₁ along a second direction,
wherein the width xₒ is longer than the first interval xi, and the length yₒ is longer than the second interval y₁,
wherein, after first photographing the sample S, the control unit moves the sample stage 60 along the first and second directions, respectively, to take second and third photographs, such that the images taken before and after the movement overlap at least partially with each other,
wherein the computation unit stitches at least the first, second, and third images to create the image of the sample..

5. The atmospheric pressure electron microscope according to claim 1 or 2,
wherein the multi-window thin film unit 50 includes a frame 51, and a through-hole 51a is formed in the frame 51,
wherein the support part 52 is attached on a lower surface of the frame 51 so that all windows 53 corresponds to the through-hole 51a, and the ultra-thin film 54 is attached on a lower surface of the support part 52 so that the ultra-thin film 54 cover all windows 53,
wherein a side surface of the through-hole 51a is formed as an inclined surface, and a diameter of an upper portion of the through-hole 51a is larger than a diameter of a lower portion of the through-hole 51a.

6. The atmospheric pressure electron microscope according to any one of claim 1 or 2,
wherein the support part 52 is a thin film having a thickness of 20nm to 1µm, which is thicker than the ultra-thin film 54, and
the ultra-thin film 54 is made of graphene or a two-dimensional material (2D material) having high electron transmittance.

7. The atmospheric pressure electron microscope according to claim 1 or 2,
wherein the atmospheric pressure electron microscope further includes a lower chamber 80 installed at a bottom of the column 10 and having a low vacuum space 81 therein,
wherein the multi-window thin film unit 50 is installed at a bottom of the lower chamber 80, and
electrons generated from the electron gun sequentially pass through the interior space, the low vacuum space 81, and the multi-window thin film unit 50 to irradiate on the sample.
